# EUROPEAN PATENT APPLICATION

(11) **EP 4 576 419 A1**
(43) Date of publication of application: **25.06.2025**
(21) Application number: 23219044.7
(22) Date of filing: 21.12.2023
(51) Int. Cl.: H01P 3/02, H01P 5/12, H05K 1/02

(54) **APPARATUS AND METHOD FOR DIFFERENTIAL SIGNAL ROUTING**

(71) Applicant: Imec VZW, 3001 Leuven (BE)
(72) Inventor: Nguyen, Johan, 1500 Halle (BE)
(74) Representative: Körfer, Thomas

(57) **Abstract**

A network (200) of this disclosure comprises a first pair of parallel distribution paths (201₁, 201₂) realized on a first metal routing layer, a second pair of parallel distribution paths (202₁, 202₂) realized on the first metal routing layer, and a first pair of parallel routing paths (203₁, 203₂) realized on a second metal routing layer being orthogonal to the first metal routing layer. In this regard, one path (203₁) of the first pair of parallel routing paths is connected to one path (201₁) of the first pair of parallel distribution paths via a first coupling path (204₁) and further to one path (202₁) of the second pair of parallel distribution paths via a second coupling path (204₂) in order to combine or split signals coming from or between the one path (201₁) of the first pair of parallel distribution paths and the one path (202₁) of the second pair of parallel distribution paths, respectively.

## Description

The invention relates to differential signal distribution, especially to splitter or combiner networks for routing high frequency, for example Radio Frequency (RF),differential signals.

The differential signal branching, from the central point of symmetry to multiple signal tapping networks, must be carefully laid out to maintain symmetry. Generally, the symmetrical distribution of wiring requires that the electrical length of the signal lines must always be identical in the two parts, i.e., the positive signal path and the negative signal path, of the differential path, and the capacitive coupling, e.g., to other lines or to the substrate, must be as similar as possible in the two parts of the differential path.

For example, the document US 2011/0032065 A1 discloses a symmetrical transformer for differential signaling. A disadvantage of US 2011/0032065 A1 is that a symmetrical distribution of wiring is not utilized for routing the differential signal to or from the symmetrical transformer, which may affect the signal integrity in terms of imbalance between positive and negative signals.

Accordingly, an object of the invention is to provide an apparatus and a method for improving the signal integrity in terms of imbalance between positive and negative signals lines of a differential signal line.

The object is solved by the features of the first independent claim for the apparatus and by the features of the second independent claim for the method. The dependent claims contain further developments.

According to a first aspect of the invention, an apparatus for differential signal routing is provided. The apparatus comprises a first network comprising a first pair of parallel distribution paths having substantially identical lengths and widths realized on a first metal routing layer, a second pair of parallel distribution paths having substantially identical lengths and widths realized on the first metal routing layer, and a first pair of parallel routing paths having substantially identical lengths and widths realized on a second metal routing layer being orthogonal to the first metal routing layer.

In this regard, one path of the first pair of parallel routing paths is connected to one path of the first pair of parallel distribution paths via a first coupling path comprising a first vertical interconnect access and further to one path of the second pair of parallel distribution paths via a second coupling path comprising a second vertical interconnect access in order to combine or split signals coming from or between the one path of the first pair of parallel distribution paths and the one path of the second pair of parallel distribution paths, respectively.

Furthermore, other path of the first pair of parallel routing paths is connected to other path of the first pair of parallel distribution paths via a third coupling path comprising a third vertical interconnect access and further to other path of the second pair of parallel distribution paths via a fourth coupling path comprising a fourth vertical interconnect access in order to combine or split signals coming from or between the other path of the first pair of parallel distribution paths and the other path of the second pair of parallel distribution paths, respectively.

Moreover, at least the first coupling path and the third coupling path have substantially identical lengths and widths, and at least the second coupling path and the fourth coupling path have substantially identical lengths and widths. Advantageously, e.g., for splitting or for combining differential signals, an imbalance between the positive signal and the negative signal of the differential signal can be drastically reduced by utilizing extreme symmetry between the positive signal path and the negative signal path, thereby improving the signal integrity.

Preferably, the first metal routing layer and the second metal routing layer correspond to back-end-of-line (BEOL) metallization structures. For example, the BEOL metallization structure may be a part of an integrated circuit, especially comprising semiconductor based wafers with planar layers. The integrated circuit may further comprise a front-end-of-line (FEOL) with active devices, such as transistors, and the BEOL for signal routing.

For example, the first metal routing layer and the second metal routing layer may be adjacent metal layers or levels of the planar integrated circuit BEOL metallization structure. In this regard, each of the vertical interconnect accesses may provide a vertical electrically conductive connection between the first metal routing layer and the second metal routing layer, thereby electrically connecting the first metal routing layer to the second metal routing layer. The first metal routing layer and the second metal routing layer may not be adjacent metal layers or levels of the planar integrated circuit BEOL metallization structure. In this regard, each of the vertical interconnect accesses may provide a vertical electrically conductive connection between the first metal routing layer and the second metal routing layer covering more layers, this is achieved by super-VIA's as known to the skilled person in the art. The super-VIA thereby electrically connecting the first metal routing layer to the non adjacent second metal routing layer.

The vertical interconnect accesses are vertically connecting the metal layer which are in a horizontal plane. So the vertical interconnect accesses are orthogonal and upward/downward oriented with respect to the metal layers.

Preferably, each of the first coupling path and the third coupling path comprises a number of turns identical to each other. Additionally or alternatively, each of the second coupling path and the fourth coupling path comprises a number of turns identical to each other.

Preferably, the first coupling path, the second coupling path, the third coupling path, and the fourth coupling path have substantially identical lengths and widths, and identical number of turns. Advantageously, for example, the symmetry between the positive signal path and the negative signal path for each of the first pair of parallel distribution paths and the second pair of parallel distribution paths can be maintained.

Preferably, the first coupling path, the second coupling path, the third coupling path, and the fourth coupling path have identical number of 45 degrees turns. In other words, the number of turns for each of the coupling paths may be identical to each other. The number of turns may comprise one or more turns between 40 degrees and 50 degrees, preferably between 42 degrees and 48 degrees, more preferably between 44 degrees and 46 degrees, most preferably one or more 45 degrees turns.

Preferably, the first coupling path, the second coupling path, the third coupling path, and the fourth coupling path have identical number of 90 degrees turns. In other words, the number of turns for each of the coupling paths may be identical to each other. The number of turns may comprise one or more turns between 85 degrees and 95 degrees, preferably between 87 degrees and 93 degrees, more preferably between 89 degrees and 91 degrees, most preferably one or more 90 degrees turns.

Alternatively, the number of turns may comprise one or more 22.5 degrees turns or other polygon shapes.

Preferably, the one path of the first pair of parallel routing paths and the first pair of parallel distribution paths overlap at their respective cross-sections. In addition, the other path of the first pair of parallel routing paths and the second pair of parallel distribution paths overlap at their respective cross-sections.

In this regard, the one path of the first pair of parallel routing paths and the first pair of parallel distribution paths may overlap at their respective cross-sections such that both the positive signal path and the negative signal path may operate with similar amount of capacitive coupling between them, e.g., formed at their respective cross-sections.

Similarly, the other path of the first pair of parallel routing paths and the second pair of parallel distribution paths may overlap at their respective cross-sections such that both the positive signal path and the negative signal path may operate with similar amount of capacitive coupling between them, e.g., formed at their respective cross-sections.

Preferably, the apparatus further comprises at least one second network. The second network comprises a second pair of parallel routing paths having substantially identical lengths and widths realized on the second metal routing layer, and a pair of vertical interconnect accesses being symmetrically arranged on the first metal routing layer with respect to the lengths of the first pair of parallel distribution paths or the second pair of parallel distribution paths, wherein each vertical interconnect access of the pair of vertical interconnect accesses is arranged on a respective distribution path of the first pair of parallel distribution paths or the second pair of parallel distribution paths.

In this regard, the second pair of parallel routing paths are respectively connected to the pair of vertical interconnect accesses via a pair of coupling paths having substantially identical lengths and widths realized on the second metal routing layer, the pair of coupling paths being symmetrically connected to the second pair of parallel routing paths with respect to the lengths of the second pair of parallel routing paths in order to couple in or out a differential signal to or from the first pair of parallel distribution paths or the second pair of parallel distribution paths, respectively.

Advantageously, e.g., for coupling in or for coupling out the differential signal, an imbalance between the positive signal and the negative signal of a differential signal can be drastically reduced by utilizing extreme symmetry between the positive signal path and the negative signal path, thereby improving the signal integrity. The second network allows to make a 90 degrees turn in both of the differential signal paths.

Preferably, the widths of the second pair of parallel routing paths and the widths of the pair of coupling paths are substantially identical to each other. Alternatively, the widths of the second pair of parallel routing paths and the widths of the pair of coupling paths are different from each other.

Advantageously, for example, the different coupling paths can be formed in a flexible manner within the design rule, e.g., to meet a certain area constraint, whereby maintain the symmetry between the positive signal path and the negative signal path.

Preferably, each path of the pair of coupling paths comprises a number of turns identical to each other, especially a number of 45 degrees turns. In other words, the number of turns for each of the coupling paths may be identical to each other. The number of turns may comprise one or more turns between 40 degrees and 50 degrees, preferably between 42 degrees and 48 degrees, more preferably between 44 degrees and 46 degrees, most preferably one or more 45 degrees turns.

Preferably, each path of the pair of coupling paths comprises a number of turns identical to each other, especially a number of 90 degrees turns. In other words, the number of turns for each of the coupling paths may be identical to each other. The number of turns may comprise one or more turns between 85 degrees and 95 degrees, preferably between 87 degrees and 93 degrees, more preferably between 89 degrees and 91 degrees, most preferably one or more 90 degrees turns.

Alternatively, the number of turns may comprise one or more 22.5 degrees turns or other polygon shapes.

Preferably, the second pair of parallel routing paths and the first pair of parallel distribution paths or the second pair of parallel distribution paths overlap at their respective cross-sections.

In this regard, the second pair of parallel routing paths and the first pair of parallel distribution paths, or the second pair of parallel routing paths and the second pair of parallel distribution paths, may overlap at their respective cross-sections such that both the positive signal path and the negative signal path may operate with similar amount of capacitive coupling, e.g., formed at their respective cross-sections.

According to a second aspect of the invention, a method is provided for differential signal routing. The method comprises a step of forming a first pair of parallel distribution paths having substantially identical lengths and widths on a first metal routing layer. The method further comprises a step of forming a second pair of parallel distribution paths having substantially identical lengths and widths on the first metal routing layer. Moreover, the method comprises a step of forming a first pair of parallel routing paths having substantially identical lengths and widths realized on a second metal routing layer being orthogonal to the first metal routing layer.

The method further comprises a step of connecting one path of the first pair of parallel routing paths to one path of the first pair of parallel distribution paths via a first coupling path comprising a first vertical interconnect access and further to one path of the second pair of parallel distribution paths via a second coupling path comprising a second vertical interconnect access.

In addition, the method comprises a step of connecting other path of the first pair of parallel routing paths to other path of the first pair of parallel distribution paths via a third coupling path comprising a third vertical interconnect access and further to other path of the second pair of parallel distribution paths via a fourth coupling path comprising a fourth vertical interconnect access.

Furthermore, the method comprises a step of combining or splitting signals coming from or between the one path of the first pair of parallel distribution paths and the one path of the second pair of parallel distribution paths, respectively, by the one path of the first pair of parallel routing paths.

Moreover, the method comprises a step of combining or splitting signals coming from or between the other path of the first pair of parallel distribution paths and the other path of the second pair of parallel distribution paths, respectively, by the other path of the first pair of parallel routing paths.

Preferably, the method further comprises a step of forming a second pair of parallel routing paths having substantially identical lengths and widths on the second metal routing layer.

In addition, the method comprises a step of symmetrically arranging a pair of vertical interconnect accesses on the first metal routing layer with respect to the lengths of the first pair of parallel distribution paths or the second pair of parallel distribution paths such that each vertical interconnect access of the pair of vertical interconnect accesses is arranged on a respective distribution path of the first pair of parallel distribution paths or the second pair of parallel distribution paths.

Furthermore, the method comprises a step of forming a pair of coupling paths having substantially identical lengths and widths on the second metal routing layer such that the pair of coupling paths being symmetrically connected to the second pair of parallel routing paths with respect to the lengths of the second pair of parallel routing paths. Moreover, the method comprises a step of respectively connecting the second pair of parallel routing paths to the pair of vertical interconnect accesses via the pair of coupling paths in order to couple in or out a differential signal to or from the first pair of parallel distribution paths or the second pair of parallel distribution paths, respectively.

The term "substantially identical" can be understood as having an identical property between multiple entities. Alternatively, the term "substantially identical" can be understood as having a property with a difference less than 10%, preferably less than 5%, more preferably less than 2%, most preferably less than 1% between multiple entities.

It is to be noted that the method according to the second aspect corresponds to the apparatus according to the first aspect and its implementation forms. Accordingly, the method of the second aspect may have corresponding implementation forms. Further, the method of the second aspect achieves the same advantages and effects as the apparatus of the first aspect and its respective implementation forms.

Exemplary embodiments of the invention are now further explained with respect to the drawings by way of example only, and not for limitation. In the drawings:
- Fig. 1: shows an exemplary embodiment of the apparatus;
- Fig. 2: shows a first exemplary embodiment of the first network;
- Fig. 3: shows a second exemplary embodiment of the first network
- Fig. 4: shows an exemplary signal flow for the network of Fig. 3;
- Fig. 5: shows a first exemplary embodiment of the second network;
- Fig. 6: shows a second exemplary embodiment of the second network;
- Fig. 7: shows an exemplary signal flow for the network of Fig. 6; and
- Fig. 8: shows an exemplary embodiment of the method.

Reference will now be made in detail to the embodiments of the present invention, examples of which are illustrated in the accompanying drawings. However, the following embodiments of the present invention may be variously modified and the range of the present invention is not limited by the following embodiments.

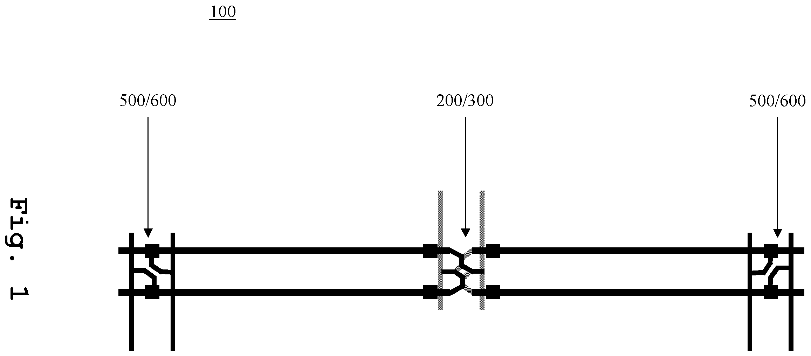

In Fig. 1, an exemplary embodiment of the apparatus 100 according to the first aspect of the invention is illustrated. The apparatus 100 may correspond to a signal splitter or a signal combiner for splitting or combining differential signals, respectively.

As the frequency of the signals in a signal distribution is increased, capacitive and inductive effect become more dominant. The capacitance and inductance of the signal paths as well as the coupling and parasitic versions of both may become more pronounced and even dominant. Mismatches in the above mentioned paths will lead to erroneous behavior of the circuits connected to the signal distribution network. To minimize common mode effects differential signal distribution is often used in high frequency applications, for example RF. The embodiments described below provide a solution for differential signal distribution to further minimize the impact of capacitive and inductive elements inherent to any signal distribution system.

For instance, the apparatus 100 may comprise a central network 200, 300 for splitting a differential signal onto two differential signal transmission lines or for combining differential signals coming from the two differential signal transmission lines. The apparatus 100 may further comprise two corner networks 500, 600 for routing the differential signals from the respective differential signal transmission lines, e.g., to or from a respective load. It is to be noted that the number of corner networks 500, 600 can be less than or more than two.

For example, the central network 200, 300 may be arranged to facilitate a central point of symmetry with respect to the corner splitters 500, 600, and symmetrical interconnection for the corner splitters 500, 600 from the central point of symmetry may be maintained to achieve an equivalent electrical length, width, and capacitive coupling in the respective positive and the negative paths of the differential signal transmission lines.

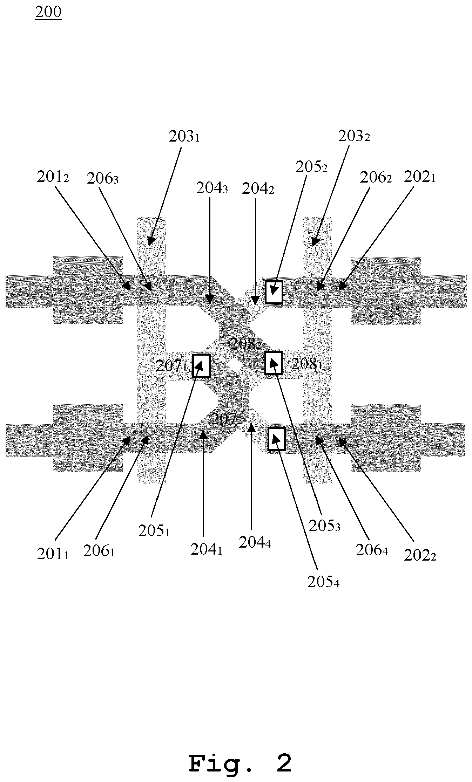

In Fig. 2, a first exemplary embodiment of the first network 200 according to the first aspect of the invention is illustrated. The first network 200 may correspond to the central network of Fig. 1.

For example, the first network 200 may comprise a first pair of distribution paths comprising a first path 201₁ and a second path 201₂, e.g., one for the positive signal (p-path) and the other for the negative signal (n-path) of the differential signal. Preferably, the first path 201₁ and the second path 201₂ of the first pair of distribution paths may have identical lengths and widths.

In this regard, the length of each of the first path 201₁ and the second path 201₂ of the first pair of distribution paths may correspond to the length or horizontal distance between the central network and one of the corner networks of Fig. 1, e.g., between the respective signal tapping points, to achieve symmetry in the horizontal signal distribution. For instance, the first path 201₁ and the second path 201₂ of the first pair of distribution paths may be realized on a first (M1) metal routing layer.

For instance, the first network 200 may comprise a second pair of distribution paths comprising a first path 202₁ and a second path 202₂, e.g., one for the positive signal (p-path) and the other for the negative signal (n-path) of the differential signal. Preferably, the first path 202₁ and the second path 202₂ of the second pair of distribution paths may have identical lengths and widths.

In this regard, the length of each of the first path 202₁ and the second path 202₂ of the second pair of distribution paths may correspond to the length or horizontal distance between the central network and one of the corner networks of Fig. 1, e.g., between the respective signal tapping points, to achieve symmetry in the horizontal signal distribution. For instance, the first path 202₁ and the second path 202₂ of the second pair of distribution paths may be realized on the M1 metal routing layer.

For example, the first network 200 may comprise a pair of routing paths comprising a first path 203₁ and a second path 203₂, e.g., one for the positive signal (p-path) and the other for the negative signal (n-path) of the differential signal. Preferably, the first path 203₁ and the second path 203₂ of the pair of routing paths may have identical lengths and widths. For instance, the first path 203₁ and the second path 203₂ of the pair of routing paths may be realized on a second (M2) metal routing layer.

In this regard, the M2 metal routing direction of the M2 routing layer may be orthogonal to the M1 metal routing direction of the M1 routing layer. This orthogonality is in the horizontal plane in which the metal layers are formed in for example integrated circuits (IC), more particularly CMOS IC's. It should be noted that the coupling paths are not restricted to the orthogonal restriction of the routing direction. As the coupling paths may comprise turns of 22.5, 45 or 90 degrees. Further the coupling paths may also comprise polygon shapes of other and multiple angles forming curves or bends if the integration technology allow for that. Preferably, the M1 metal routing layer and the M2 metal routing layer may be adjacent metal routing layers. The first and second metal layers can be interchanged. The first and second metal layers may be layers with other metal layers in between the first and second metal layers. In these embodiments the vertical interconnect accesses are covering multiple metal layers to cover the distance between the first and the second layer, this is achieved by so called super-VIA's, which are known in the art. The VIA's or super-VIA's are vertical interconnect structures so are orthogonal to the plane of the metal layers in planar integration technologies for fabricating IC's.

For instance, the first path 203₁ of the pair of routing paths may be connected to the first path 201₁ of the first pair of distribution paths via a first coupling path 204₁. In this regard, a first vertical interconnect access (VIA) 205₁ may be arranged on the first coupling path 204₁ to vertically connect the M1 metal routing layer and the M2 metal routing layer, thereby interconnecting the first path 203₁ of the pair of routing paths and the first path 201₁ of the first pair of distribution paths.

For example, the first coupling path 204₁ may comprise four successive 45 degrees turns. However, the first coupling path 204₁ may comprise more than or less than four 45 degrees turns. Alternatively, the first coupling path 204₁ may comprise a number of successive 22.5 degrees turns. Alternatively, the first coupling path 204₁ may be realized in any polygon shapes that can be achieved within the design rule.

For instance, the first path 203₁ of the pair of routing paths may be further connected to the first path 202₁ of the second pair of distribution paths via a second coupling path 204₂. In this regard, a second VIA 205₂ may be arranged on the second coupling path 204₂ to vertically connect the M1 metal routing layer and the M2 metal routing layer, thereby interconnecting the first path 203₁ of the pair of routing paths and the first path 202₁ of the second pair of distribution paths.

For example, the second coupling path 204₂ may comprise four successive 45 degrees turns. However, the second coupling path 204₂ may comprise more than or less than four 45 degrees turns. Alternatively, the second coupling path 204₂ may comprise a number of successive 22.5 degrees turns. Alternatively, the second coupling path 204₂ may be realized in any polygon shapes that can be achieved within the design rule.

In this regard, the first path 203₁ of the pair of routing paths may combine or split signals coming from or between the first path 201₁ of the first pair of distribution paths and the first path 202₁ of the second pair of distribution paths, respectively.

For instance, the second path 203₂ of the pair of routing paths may be connected to the second path 201₂ of the first pair of distribution paths via a third coupling path 204₃. In this regard, a third VIA 205₃ may be arranged on the third coupling path 204₃ to vertically connect the M1 metal routing layer and the M2 metal routing layer, thereby interconnecting the second path 203₂ of the pair of routing paths and the second path 201₂ of the first pair of distribution paths.

For example, the third coupling path 204₃ may comprise four successive 45 degrees turns. However, the third coupling path 204₃ may comprise more than or less than four 45 degrees turns. Alternatively, the third coupling path 204₃ may comprise a number of successive 22.5 degrees turns.

Alternatively, the third coupling path 204₃ may be realized in any polygon shapes that can be achieved within the design rule.

For instance, the second path 203₂ of the pair of routing paths may be further connected to the second path 202₂ of the second pair of distribution paths via a fourth coupling path 204₄. In this regard, a fourth VIA 205₄ may be arranged on the fourth coupling path 204₄ to vertically connect the M1 metal routing layer and the M2 metal routing layer, thereby interconnecting the second path 203₂ of the pair of routing paths and the second path 202₂ of the second pair of distribution paths.

For example, the fourth coupling path 204₄ may comprise four successive 45 degrees turns. However, the fourth coupling path 204₄ may comprise more than or less than four 45 degrees turns. Alternatively, the fourth coupling path 204₄ may comprise a number of successive 22.5 degrees turns. Alternatively, the fourth coupling path 204₄ may be realized in any polygon shapes.

In this regard, the second path 203₂ of the pair of routing paths may combine or split signals coming from or between the second path 201₂ of the first pair of distribution paths and the second path 202₂ of the second pair of distribution paths, respectively.

Preferably, the first coupling path 204₁ and the third coupling path 204₃ may have identical lengths, identical widths, identical number of turns, and/or identical polygon shapes. Additionally, the second coupling path 204₂ and the fourth coupling path 204₄ may have identical lengths, identical widths, identical number of turns, and/or identical polygon shapes.

More preferably, the first coupling path 204₁, the second coupling path 204₂, the third coupling path 204₃, and the fourth coupling path 204₄ may have identical lengths, identical widths, identical number of turns, and/or identical polygon shapes.

For example, the first coupling path 204₁ may comprise a first portion 207₁ realized on the M2 metal layer being connected to the first path 203₁ of the pair of routing paths. The first coupling path 204₁ may further comprise a second portion 207₂ realized on the M1 metal layer being connected to the first path 201₁ of the first pair of distribution paths. In this regard, the first VIA 205₁ may interconnect the first portion 207₁ and the second portion 207₂ of the first coupling path 204₁.

For instance, the second coupling path 204₂ may be realized on the M2 metal layer being connected to the first path 203₁ of the pair of routing paths, e.g., forming a common branching point for both the first coupling path 204₁ and the second coupling path 204₂ from the first path 203₁ of the pair of routing paths. In this regard, the second VIA 205₂ may interconnect the second coupling path 204₂ and the first path 202₁ of the second pair of distribution paths.

For example, the third coupling path 204₃ may comprise a first portion 208₁ realized on the M2 metal layer being connected to the second path 203₂ of the pair of routing paths. The third coupling path 204₃ may further comprise a second portion 208₂ realized on the M1 metal layer being connected to the second path 201₂ of the first pair of distribution paths. In this regard, the third VIA 205₃ may interconnect the first portion 208₁ and the second portion 208₂ of the third coupling path 204₃.

For instance, the fourth coupling path 204₄ may be realized on the M2 metal layer being connected to the second path 203₂ of the pair of routing paths, e.g., forming a common branching point for both the third coupling path 204₃ and the fourth coupling path 204₄ from the second path 203₂ of the pair of routing paths. In this regard, the fourth VIA 205₄ may interconnect the fourth coupling path 204₄ and the second path 202₂ of the second pair of distribution paths.

Preferably, the common branching point on the first path 203₁ of the pair of routing paths and the common branching point on the second path 203₂ of the pair of routing paths may be realized in a symmetrical manner with respect to the lengths of the pair of routing paths, i.e., at a distance along the length of each path of the pair of routing paths that is equivalent or identical to each other.

For example, the first path 203₁ of the pair of routing paths and the first path 201₁ of the first pair of distribution paths may overlap at a first cross-section 206₁. In addition, the second path 203₂ of the pair of routing paths and the first path 202₁ of the second pair of distribution paths may overlap at a second cross-section 206₂.

Furthermore, the first path 203₁ of the pair of routing paths and the second path 201₂ of the first pair of distribution paths may overlap at a third cross-section 206₃. Moreover, the second path 203₂ of the pair of routing paths and the second path 202₂ of the second pair of distribution paths may overlap at a fourth cross-section 206₄.

In this regard, at the first cross-section 206₁, the first path 203₁ of the pair of routing paths and the first path 201₁ of the first pair of distribution paths may operate in-phase, which may result in the coupling capacitance between two in-phase signals. In addition, at the second cross-section 206₂, the second path 203₂ of the pair of routing paths and the first path 202₁ of the second pair of distribution paths may operate in antiphase, which may result in the coupling capacitance between two antiphase signals.

Furthermore, at the third cross-section 206₃, the first path 203₁ of the pair of routing paths and the second path 201₂ of the first pair of distribution paths may operate in antiphase, which may result in the coupling capacitance between two antiphase signals. Moreover, at the fourth cross-section 206₄, the second path 203₂ of the pair of routing paths and the second path 202₂ of the second pair of distribution paths may operate in-phase, which may result in the coupling capacitance between two in-phase signals.

In other words, the differential signal path from the first path 203₁ of the pair of routing paths to the first path 201₁ of the first pair of distribution paths via the first coupling path 204₁ and the differential signal path from the second path 203₂ of the pair of routing paths to the second path 201₂ of the first pair of distribution paths via the third coupling path 204₃ may experience an equivalent electrical length, width, line inductance, and an equivalent amount of coupling capacitance.

Analogously, the differential signal path from the first path 203₁ of the pair of routing paths to the first path 202₁ of the second pair of distribution paths via the second coupling path 204₂ and the differential signal path from the second path 203₂ of the pair of routing paths to the second path 202₂ of the second pair of distribution paths via the fourth coupling path 204₄ may experience an equivalent electrical length, width, line inductance, and an equivalent amount of coupling capacitance.

Therefore, especially due to the extreme symmetry between the p-path and the n-path of the differential signal paths, equivalent electrical length, width, line inductance, and an equivalent amount of coupling capacitance can be achieved for the p-path and the n-path, thereby improving the signal integrity.

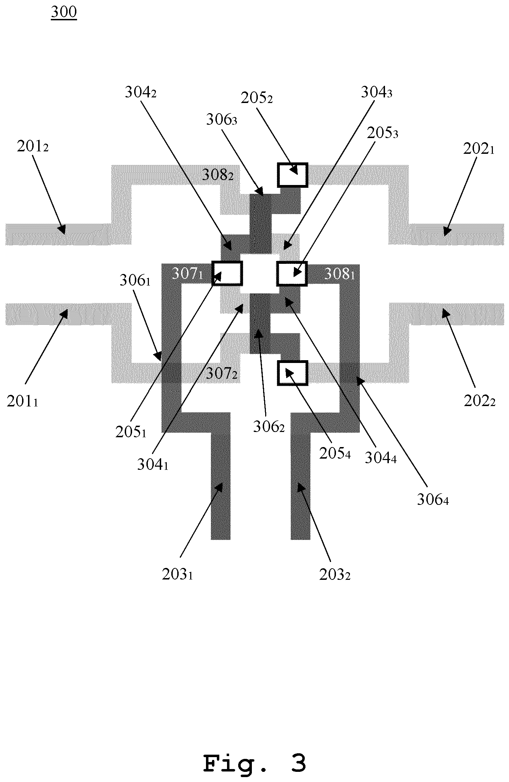

In Fig. 3, a second exemplary embodiment of the first network 300 according to the first aspect of the invention is illustrated. The first network 300 may correspond to the central network of Fig. 1. The first network 300 may differ from the first network 200 in that the first coupling path 304₁, the second coupling path 304₂, the third coupling path 304₃, and the fourth coupling path 304₄ may have a number of consecutive 90 degrees turns.

For example, the first coupling path 304₁ may comprise a first portion 307₁ realized on the M2 metal layer (shown as darker grayscale) by extending the first path 203₁ of the pair of routing paths. The first coupling path 304₁ may further comprise a second portion 307₂ realized on the M1 metal layer (shown as lighter grayscale) being extended from the first path 201₁ of the first pair of distribution paths. In this regard, the first VIA 205₁ may interconnect the first portion 307₁ and the second portion 307₂ of the first coupling path 304₁.

For instance, the second coupling path 304₂ may be realized on the M2 metal layer by extending the first path 203₁ of the pair of routing paths, e.g., forming a common branching point for both the first coupling path 304₁ and the second coupling path 304₂ at the first VIA 205₁. In this regard, the second VIA 205₂ may interconnect the second coupling path 304₂ and the first path 202₁ of the second pair of distribution paths.

For example, the third coupling path 304₃ may comprise a first portion 308₁ realized on the M2 metal layer by extending the second path 203₂ of the pair of routing paths. The third coupling path 304₃ may further comprise a second portion 308₂ realized on the M1 metal layer being extended from the second path 201₂ of the first pair of distribution paths. In this regard, the third VIA 205₃ may interconnect the first portion 308₁ and the second portion 308₂ of the third coupling path 304₃.

For instance, the fourth coupling path 304₄ may be realized on the M2 metal layer by extending the second path 203₂ of the pair of routing paths, e.g., forming a common branching point for both the third coupling path 304₃ and the fourth coupling path 304₄ at the third VIA 205₃. In this regard, the fourth VIA 405₄ may interconnect the fourth coupling path 304₄ and the second path 202₂ of the second pair of distribution paths.

Preferably, the first coupling path 304₁ and the third coupling path 304₃ may have identical lengths, identical widths, identical number of turns, and/or identical shapes. Additionally, the second coupling path 304₂ and the fourth coupling path 304₄ may have identical lengths, identical widths, identical number of turns, and/or identical shapes.

More preferably, the first coupling path 304₁, the second coupling path 304₂, the third coupling path 304₃, and the fourth coupling path 304₄ may have identical lengths, identical widths, identical number of turns, and/or identical shapes.

For example, the first portion 307₁ and the second portion 307₂ of the first coupling path 304₁ may overlap at a first cross-section 306₁. In addition, the second portion 307₂ of the first coupling path 304₁ and the fourth coupling path 304₄ may overlap at a second cross-section 306₂. Furthermore, the second coupling path 304₂ and the second portion 308₂ of the third coupling path 304₃ may overlap at a third cross-section 306₃. Moreover, the first portion 308₁ of the third coupling path 304₃ and the fourth coupling path 304₄ may overlap at a fourth cross-section 306₄.

In this regard, at the first cross-section 306₁, the crossed-over paths may operate in-phase, which may result in the coupling capacitance between two in-phase signals. In addition, at the second cross-section 306₂, the crossed-over paths may operate in antiphase, which may result in the coupling capacitance between two antiphase signals.

Furthermore, at the third cross-section 306₃, the crossed-over paths may operate in antiphase, which may result in the coupling capacitance between two antiphase signals. Moreover, at the fourth cross-section 306₄, the crossed-over paths may operate in-phase, which may result in the coupling capacitance between two in-phase signals.

In other words, the differential signal path from the first path 203₁ of the pair of routing paths to the first path 201₁ of the first pair of distribution paths via the first coupling path 304₁ and the differential signal path from the second path 203₂ of the pair of routing paths to the second path 201₂ of the first pair of distribution paths via the third coupling path 304₃ may experience an equivalent electrical length, width, line inductance, and an equivalent amount of coupling capacitance.

Analogously, the differential signal path from the first path 203₁ of the pair of routing paths to the first path 202₁ of the second pair of distribution paths via the second coupling path 304₂ and the differential signal path from the second path 203₂ of the pair of routing paths to the second path 202₂ of the second pair of distribution paths via the fourth coupling path 304₄ may experience an equivalent electrical length, width, line inductance, and an equivalent amount of coupling capacitance.

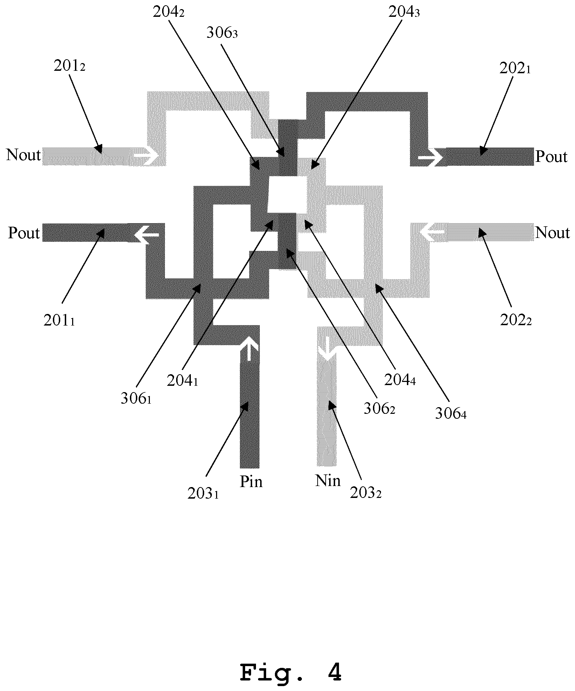

In Fig. 4, an exemplary signal flow for the network 300 is illustrated. In particular, a split operation of a differential signal Pin, Nin from the pair of routing paths 203₁, 203₂ to the first pair of distribution paths 201₁, 201₂ and the second pair of distribution path 202₁, 202₂ is illustrated. In this example, the p-path is shown in the darker grayscale and the n-path is shown in the lighter grayscale.

The positive signal Pin may be inputted from the first path 203₁ of the pair of routing paths and may be split between the first path 201₁ of the first pair of distribution paths and the first path 202₁ of the second pair of distribution paths (shown as Pout). Similarly, the negative signal Nin may be inputted from the second path 203₂ of the pair of routing paths and may be split between the second path 201₂ of the first pair of distribution paths and the second path 202₂ of the second pair of distribution paths (shown as Nout).

It can be seen that the signal path Pin-Pout from the first path 203₁ of the pair of routing paths to the first path 201₁ of the first pair of distribution paths and the signal path Nin-Nout from the second path 203₂ of the pair of routing paths to the second path 201₂ of the first pair of distribution paths may experience an equivalent electrical length, width, line inductance, and an equivalent amount of coupling capacitance.

Analogously, the signal path Pin-Pout from the first path 203₁ of the pair of routing paths to the first path 202₁ of the second pair of distribution paths and the signal path Nin-Nout from the second path 203₂ of the pair of routing paths to the second path 202₂ of the second pair of distribution paths may experience an equivalent electrical length, width, line inductance, and an equivalent amount of coupling capacitance.

It will be clear for the skilled person that if in fig 4. the inputs and outputs are interchanged and the signal direction indicated by the arrows are in opposite direction then the signal splitter operation will change to a signal combiner.

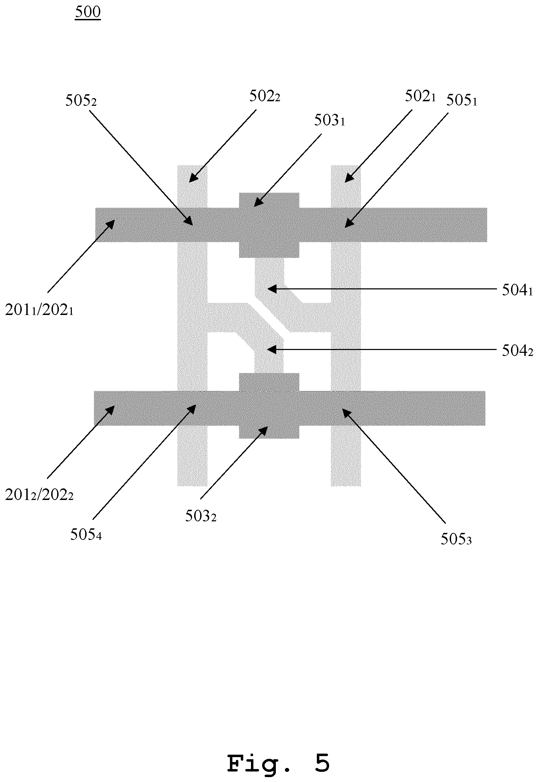

In Fig. 5, a first exemplary embodiment of the second network 500 according to the first aspect of the invention is illustrated. The second network 500 may correspond to the corner network of Fig. 1.

For example, the second network 500 may comprise a pair of distribution paths. The pair of distribution paths may correspond to the first pair of distribution paths 201₁, 201₂ or the second pair of distribution paths 202₁, 202₂ of the first network 200, 300 as shown in Fig. 2 to Fig. 4. It is to be noted, in the following, only the first pair of distribution paths 201₁, 201₂ is considered, and the implementation is analogous for the second pair of distribution paths 202₁, 202₂.

As mentioned before, the pair of distribution paths may comprise the first path 201₁ and the second path 201₂, e.g., one for the positive signal (p-path) and the other for the negative signal (n-path) of the differential signal, which may have identical lengths and widths.

In this regard, the length of each of the first path 201₁ and the second path 201₂ of the pair of distribution paths may correspond to the length or horizontal distance between the central network and one of the corner networks of Fig. 1, e.g., between the respective signal tapping points, to achieve symmetry in the horizontal signal distribution.

Furthermore, the first path 201₁ and the second path 201₂ of the pair of distribution paths may be realized on the M1 metal routing layer.

For example, the second network 500 may comprise a pair of routing paths comprising a first path 502₁ and a second path 502₂, e.g., one for the positive signal (p-path) and the other for the negative signal (n-path) of the differential signal. Preferably, the first path 502₁ and the second path 502₂ of the pair of routing paths may have identical lengths and widths. For instance, the first path 502₁ and the second path 502₂ of the pair of routing paths may be realized on the M2 metal routing layer.

As mentioned before, the signal routing direction of the signal paths in the M2 metal routing layer may be orthogonal to the signal routing direction of the signal paths in the M1 metal routing layer. Preferably, the M1 metal routing layer and the M2 metal routing layer may be adjacent metal routing layers.

For instance, the first path 502₁ of the pair of routing paths may be connected to the first path 201₁ of the pair of distribution paths via a first coupling path 504₁. The first coupling path 504₁ may be realized on the M2 metal routing layer being connected to the first path 502₁ of the pair of routing paths and further to the first path 201₁ of the pair of distribution paths through a first VIA 503₁.

In this regard, the first VIA 503₁ may be arranged on the first path 201₁ of the pair of distribution paths to vertically connect the M1 metal routing layer and the M2 metal routing layer, thereby interconnecting the first coupling path 504₁ and the first path 201₁ of the pair of distribution paths.

For example, the second path 502₂ of the pair of routing paths may be connected to the second path 201₂ of the pair of distribution paths via a second coupling path 504₂. The second coupling path 504₂ may be realized on the M2 metal routing layer being connected to the second path 502₂ of the pair of routing paths and further to the second path 201₂ of the pair of distribution paths through a second VIA 503₂.

In this regard, the second VIA 503₂ may be arranged on the second path 201₂ of the pair of distribution paths to vertically connect the M1 metal routing layer and the M2 metal routing layer, thereby interconnecting the second coupling path 504₂ and the second path 201₂ of the first of distribution paths.

For example, the first path 502₁ of the pair of routing paths may route a signal to or from the first path 201₁ of the pair of distribution paths via the first coupling path 504₁ and the second path 502₂ of the pair of routing paths may route a signal to or from the second path 201₂ of the pair of distribution paths via the second coupling path 504₂.

For example, the first coupling path 504₁ and the second coupling path 504₂ may be connected to the first path 502₁ of the pair of routing paths and the second path 502₂ of the pair of routing paths, respectively, at points symmetrical to each other, i.e., at a distance along the length of each path of the pair of routing paths that is equivalent or identical to each other.

In addition, the first VIA 503₁ and the second VIA 503₂ may be arranged on the first path 201₁ of the pair of distribution paths and the second path 201₂ of the pair of distribution paths, respectively, at points symmetrical to each other, i.e., at a distance along the length of each path of the pair of distribution paths that is equivalent or identical to each other.

For example, the first coupling path 504₁ may comprise two successive 45 degrees turns. However, the first coupling path 504₁ may comprise more than or less than two 45 degrees turns. Alternatively, the first coupling path 504₁ may comprise a number of successive 22.5 degrees turns. Alternatively, the first coupling path 504₁ may be realized in any polygon shapes that can be achieved within the design rule.

In addition, the second coupling path 504₂ may comprise two successive 45 degrees turns. However, the second coupling path 504₂ may comprise more than or less than two 45 degrees turns. Alternatively, the second coupling path 504₂ may comprise a number of successive 22.5 degrees turns. Alternatively, the second coupling path 504₂ may be realized in any polygon shapes that can be achieved within the design rule.

For example, the first coupling path 504₁ and the first path 502₁ of the pair of routing paths may have identical widths. In addition, the second coupling path 504₂ and the second path 502₂ of the pair of routing paths may have identical widths. Preferably, the first coupling path 504₁ and the second coupling path 504₂ may have identical lengths, widths, identical number of turns, and/or identical polygon shapes.

For example, the first path 502₁ of the pair of routing paths and the first path 201₁ of the pair of distribution paths may overlap at a first cross-section 505₁. In addition, the second path 502₂ of the pair of routing paths and the first path 201₁ of the pair of distribution paths may overlap at a second cross-section 505₂.

Furthermore, the first path 502₁ of the pair of routing paths and the second path 201₂ of the pair of distribution paths may overlap at a third cross-section 505₃. Moreover, the second path 502₂ of the pair of routing paths and the second path 202₂ of the pair of distribution paths may overlap at a fourth cross-section 505₄.

In this regard, at the first cross-section 505₁, the first path 502₁ of the pair of routing paths and the first path 201₁ of the pair of distribution paths may operate in-phase, which may result in the coupling capacitance between two in-phase signals. In addition, at the second cross-section 505₂, the second path 502₂ of the pair of routing paths and the first path 201₁ of the pair of distribution paths may operate in antiphase, which may result in the coupling capacitance between two antiphase signals.

Furthermore, at the third cross-section 505₃, the first path 502₁ of the pair of routing paths and the second path 201₂ of the pair of distribution paths may operate in antiphase, which may result in the coupling capacitance between two antiphase signals. Moreover, at the fourth cross-section 505₄, the second path 502₂ of the pair of routing paths and the second path 202₂ of the pair of distribution paths may operate in-phase, which may result in the coupling capacitance between two in-phase signals.

In other words, the differential signal path from the first path 502₁ of the pair of routing paths to the first path 201₁ of the pair of distribution paths via the first coupling path 504₁ and the differential signal path from the second path 502₂ of the pair of routing paths to the second path 201₂ of the pair of distribution paths via the second coupling path 504₂ may experience an equivalent electrical length, width, line inductance, and an equivalent amount of coupling capacitance.

Therefore, especially due to the extreme symmetry between the p-path and the n-path of the differential signal paths, equivalent electrical length, width, line inductance, and an equivalent amount of coupling capacitance can be achieved for the p-path and the n-path, thereby improving the signal integrity.

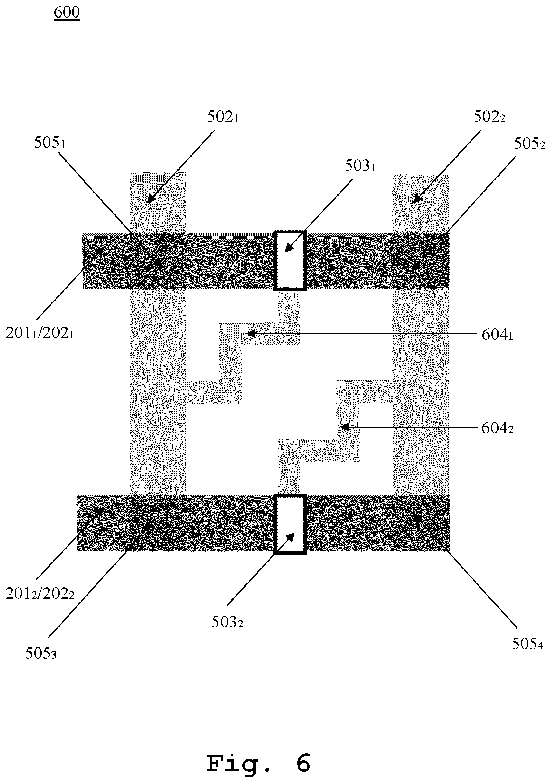

In Fig. 6, a second exemplary embodiment of the second network 600 according to the first aspect of the invention is illustrated. The second network 600 may correspond to the corner network of Fig. 1. The second network 600 may differ from the second network 500 in that the first coupling path 604₁ and the second coupling path 604₂ may have a number of consecutive 90 degrees turns.

For example, the first coupling path 604₁ may comprise three successive 90 degrees turns. However, the first coupling path 604₁ may comprise more than or less than three 90 degrees turns. In addition, the second coupling path 604₂ may comprise three successive 90 degrees turns. However, the second coupling path 604₂ may comprise more than or less than three 90 degrees turns.

For example, the first coupling path 604₁ may have a smaller width than the width of the first path 502₁ of the pair of routing paths. In addition, the second coupling path 604₂ may have a smaller width than the width of the second path 502₂ of the pair of routing paths. However, the first coupling path 604₁ and the second coupling path 604₂ may have identical lengths, widths, identical number of turns, and/or identical polygon shapes with respect to each other.

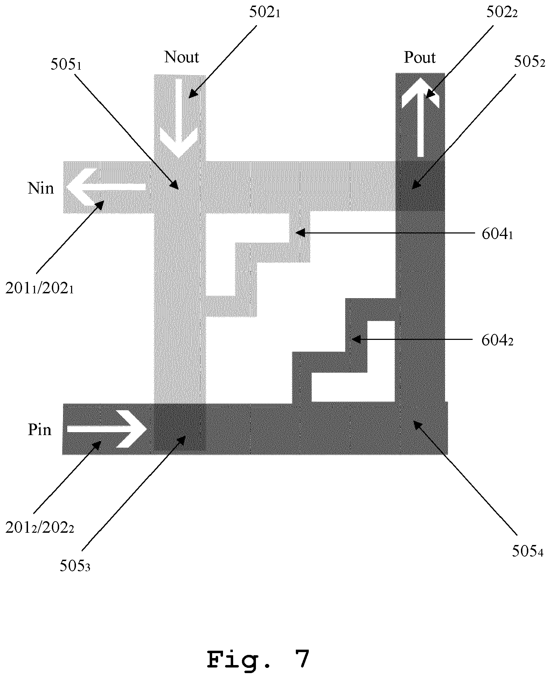

In Fig. 7, an exemplary signal flow for the network 600 is illustrated. In particular, a routing operation of a differential signal Pin, Nin from the pair of distribution paths 201₁, 201₂ to the pair of routing paths 502₁, 502₂ is illustrated. In this example, the p-path is shown in the darker grayscale and the n-path is shown in the lighter grayscale.

The negative signal Nin may be inputted from the first path 201₁ of the pair of distribution paths and may be routed (shown as Nout) to the first path 502₁ of the pair of routing paths via the first coupling path 604₁. Similarly, the positive signal Pin may be inputted from the second path 201₂ of the pair of distribution paths and may be routed (shown as Pout) to the second path 502₂ of the pair of routing paths via the second coupling path 604₂.

It can be seen that the signal path Nin-Nout from the first path 201₁ of the pair of distribution paths to the first path 502₁ of the pair of routing paths and the signal path Pin-Pout from the second path 201₂ of the pair of distribution paths to the second path 502₂ of the pair of routing paths may experience an equivalent electrical length, width, line inductance, and an equivalent amount of coupling capacitance.

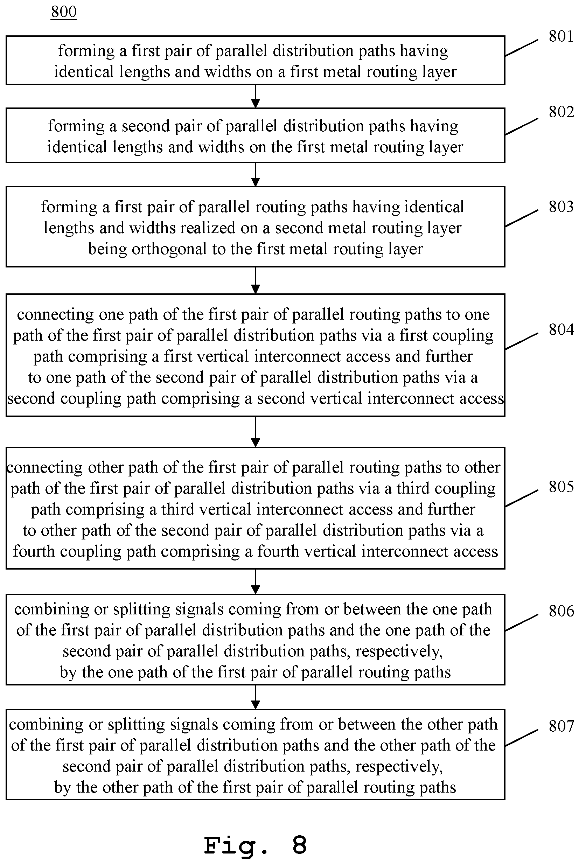

In Fig. 8, an exemplary embodiment of the method 800 according to the second aspect of the invention is illustrated. In a first step 801, a first pair of parallel distribution paths having identical lengths and widths is formed on a first metal routing layer. In a second step 802, a second pair of parallel distribution paths having identical lengths and widths is formed on the first metal routing layer. In a third step 803, a first pair of parallel routing paths having identical lengths and widths is formed on a second metal routing layer being orthogonal to the first metal routing layer.

In a fourth step 804, one path of the first pair of parallel routing paths is connected to one path of the first pair of parallel distribution paths via a first coupling path comprising a first vertical interconnect access and further to one path of the second pair of parallel distribution paths via a second coupling path comprising a second vertical interconnect access.

In a fifth step 805, other path of the first pair of parallel routing paths is connected to other path of the first pair of parallel distribution paths via a third coupling path comprising a third vertical interconnect access and further to other path of the second pair of parallel distribution paths via a fourth coupling path comprising a fourth vertical interconnect access.

In a sixth step 806, signals coming from or between the one path of the first pair of parallel distribution paths and the one path of the second pair of parallel distribution paths are combined or split, respectively, by the one path of the first pair of parallel routing paths. In a seventh step 807, signals coming from or between the other path of the first pair of parallel distribution paths and the other path of the second pair of parallel distribution paths are combined or split, respectively, by the other path of the first pair of parallel routing paths.

It is important to note that, in the description as well as in the claims, the word "comprising" does not exclude other elements or steps and the indefinite article "a" or "an" does not exclude a plurality. A single element or other unit may fulfill the functions of several entities or items recited in the claims.

It should be understood that the term "and/or" used in the specification and the appended claims of this application refers to any combination and all possible combinations of one or more associated listed items, and includes these combinations. It should also be understood that the word "connected" implies that the elements may be directly connected together or may be coupled through one or more intervening elements. Moreover, the disclosure with regard to any of the aspects is also relevant with regard to the other aspects of the disclosure.

Although the invention has been illustrated and described with respect to one or more implementations, equivalent alterations and modifications will occur to others skilled in the art upon the reading and understanding of this specification and the annexed drawings. In addition, while a particular feature of the invention may have been disclosed with respect to only one of several implementations, such feature may be combined with one or more other features of the other implementations as may be desired and advantageous for any given or particular application.

## Claims

1. An apparatus (100) for differential signal routing, the apparatus comprises a first network (200, 300) comprising:
a first pair of parallel distribution paths (201₁, 201₂) having substantially identical lengths and widths realized on a first metal routing layer,
a second pair of parallel distribution paths (202₁, 202₂) having substantially identical lengths and widths realized on the first metal routing layer, and
a first pair of parallel routing paths (203₁, 203₂) having substantially identical lengths and widths realized on a second metal routing layer being orthogonal to the first metal routing layer,
wherein one path (203₁) of the first pair of parallel routing paths is connected to one path (201₁) of the first pair of parallel distribution paths via a first coupling path (204₁, 304₁) comprising a first vertical interconnect access (205₁) and further to one path (202₁) of the second pair of parallel distribution paths via a second coupling path (204₂, 304₂) comprising a second vertical interconnect access (205₂) in order to combine or split signals coming from or between the one path (201₁) of the first pair of parallel distribution paths and the one path (202₁) of the second pair of parallel distribution paths, respectively,
wherein other path (203₂) of the first pair of parallel routing paths is connected to other path (201₂) of the first pair of parallel distribution paths via a third coupling path (204₃, 304₃) comprising a third vertical interconnect access (205₃) and further to other path (202₂) of the second pair of parallel distribution paths via a fourth coupling path (204₄, 304₄) comprising a fourth vertical interconnect access (205₄) in order to combine or split signals coming from or between the other path (201₂) of the first pair of parallel distribution paths and the other path (202₂) of the second pair of parallel distribution paths, respectively, wherein at least the first coupling path (204₁, 304₁) and the third coupling path (204₃, 304₃) have substantially identical lengths and widths, and at least the second coupling path (204₂, 304₂) and the fourth coupling path (204₄, 304₄) have substantially identical lengths and widths.

2. The apparatus according to claim 1,
wherein the first metal routing layer and the second metal routing layer correspond to back-end-of-line, BEOL, metallization structures.

3. The apparatus according to claim 1 or 2,
wherein each of the first coupling path (204₁, 304₁) and the third coupling path (204₃, 304₃) comprises a number of turns identical to each other, and/or
wherein each of the second coupling path (204₂, 304₂) and the fourth coupling path (204₄, 304₄) comprises a number of turns identical to each other.

4. The apparatus according to any of claims 1 to 3, wherein the first coupling path (204₁, 304₁), the second coupling path (204₂, 304₂), the third coupling path (204₃, 304₃), and the fourth coupling path (204₄, 304₄) have substantially identical lengths, widths, and identical number of turns.

5. The apparatus according to any of claims 1 to 4, wherein the first coupling path (204₁, 304₁), the second coupling path (204₂, 304₂), the third coupling path (204₃, 304₃), and the fourth coupling path (204₄, 304₄) have identical number of 45 degree turns.

6. The apparatus according to any of claims 1 to 4, wherein the first coupling path (204₁, 304₁), the second coupling path (204₂, 304₂), the third coupling path (204₃, 304₃), and the fourth coupling path (204₄, 304₄) have identical number of 90 degree turns.

7. The apparatus according to any of claims 1 to 6, wherein the one path (203₁) of the first pair of parallel routing paths and the first pair of parallel distribution paths (201₁, 201₂) overlap at their respective cross-sections (206₁, 206₃), and
wherein the other path (203₂) of the first pair of parallel routing paths and the second pair of parallel distribution paths (202₁, 202₂) overlap at their respective cross-sections (206₂, 206₄).

8. The apparatus according to any of claims 1 to 7, wherein the apparatus further comprises at least one second network (500, 600) comprising:
a second pair of parallel routing paths (502₁, 502₂) having substantially identical lengths and widths realized on the second metal routing layer, and
a pair of vertical interconnect accesses (503₁, 503₂) being symmetrically arranged on the first metal routing layer with respect to the lengths of the first pair of parallel distribution paths (201₁, 201₂) or the second pair of parallel distribution paths (202₁, 202₂), wherein each vertical interconnect access of the pair of vertical interconnect accesses (503₁, 503₂) is arranged on a respective distribution path of the first pair of parallel distribution paths (201₁, 201₂) or the second pair of parallel distribution paths (202₁, 202₂),
wherein the second pair of parallel routing paths (502₁, 502₂) are respectively connected to the pair of vertical interconnect accesses (503₁, 503₂) via a pair of coupling paths (504₁, 504₂, 604₁, 604₂) having substantially identical lengths and widths realized on the second metal routing layer, the pair of coupling paths (504₁, 504₂, 604₁, 604₂) being symmetrically connected to the second pair of parallel routing paths (502₁, 502₂) with respect to the lengths of the second pair of parallel routing paths (502₁, 502₂) in order to couple in or out a differential signal to or from the first pair of parallel distribution paths (201₁, 201₂) or the second pair of parallel distribution paths (202₁, 202₂), respectively.

9. The apparatus according to claim 8,
wherein the widths of the second pair of parallel routing paths (502₁, 502₂) and the widths of the pair of coupling paths (504₁, 504₂) are substantially identical to each other.

10. The apparatus according to claim 8,
wherein the widths of the second pair of parallel routing paths (502₁, 502₂) and the widths of the pair of coupling paths (604₁, 604₂) are different from each other.

11. The apparatus according to any of claims 8 to 10, wherein each path of the pair of coupling paths (504₁, 504₂, 604₁, 604₂) comprises a number of turns identical to each other, especially a number of 45 degree turns.

12. The apparatus according to any of claims 8 to 10, wherein each path of the pair of coupling paths (504₁, 504₂, 604₁, 604₂) comprises a number of turns identical to each other, especially a number of 90 degree turns.

13. The apparatus according to any of claims 8 to 12, wherein the second pair of parallel routing paths (502₁, 502₂) and the first pair of parallel distribution paths (201₁, 201₂) or the second pair of parallel distribution paths (202₁, 202₂) overlap at their respective cross-sections.

14. A method (800) for differential signal routing comprising:
forming (801) a first pair of parallel distribution paths having substantially identical lengths and widths on a first metal routing layer,
forming (802) a second pair of parallel distribution paths having substantially identical lengths and widths on the first metal routing layer,
forming (803) a first pair of parallel routing paths having substantially identical lengths and widths realized on a second metal routing layer being orthogonal to the first metal routing layer,
connecting (804) one path of the first pair of parallel routing paths to one path of the first pair of parallel distribution paths via a first coupling path comprising a first vertical interconnect access and further to one path of the second pair of parallel distribution paths via a second coupling path comprising a second vertical interconnect access,
connecting (805) other path of the first pair of parallel routing paths to other path of the first pair of parallel distribution paths via a third coupling path comprising a third vertical interconnect access and further to other path of the second pair of parallel distribution paths via a fourth coupling path comprising a fourth vertical interconnect access,
combining or splitting (806) signals coming from or between the one path of the first pair of parallel distribution paths and the one path of the second pair of parallel distribution paths, respectively, by the one path of the first pair of parallel routing paths, and
combining or splitting (807) signals coming from or between the other path of the first pair of parallel distribution paths and the other path of the second pair of parallel distribution paths, respectively, by the other path of the first pair of parallel routing paths.

15. The method according to claim 14,
wherein the method further comprises:
forming a second pair of parallel routing paths having substantially identical lengths and widths on the second metal routing layer,
symmetrically arranging a pair of vertical interconnect accesses on the first metal routing layer with respect to the lengths of the first pair of parallel distribution paths or the second pair of parallel distribution paths such that each vertical interconnect access of the pair of vertical interconnect accesses is arranged on a respective distribution path of the first pair of parallel distribution paths or the second pair of parallel distribution paths,
forming a pair of coupling paths having substantially identical lengths and widths on the second metal routing layer such that the pair of coupling paths being symmetrically connected to the second pair of parallel routing paths with respect to the lengths of the second pair of parallel routing paths, and
respectively connecting the second pair of parallel routing paths to the pair of vertical interconnect accesses via the pair of coupling paths in order to couple in or out a differential signal to or from the first pair of parallel distribution paths or the second pair of parallel distribution paths, respectively.
